# EUROPEAN PATENT APPLICATION

(11) **EP 4 485 807 A1**
(43) Date of publication of application: **01.01.2025**
(21) Application number: 23216653.8
(22) Date of filing: 14.12.2023
(51) Int. Cl.: H04B 1/10, H04B 1/401, H04B 15/00, G06F 1/04

(54) **ARCHITECTURE FOR REDUCTION OF RF INTERFERENCE ON CLOCK CIRCUITS**

(30) Priority: 27.06.2023 US 202318214885
(71) Applicant: INTEL Corporation, Santa Clara, CA 95054 (US)
(72) Inventor: ALBAN, Eduardo, Hillsboro, 97124 (US); KURD, Nasser, Portland, 97229 (US); LUO, Hao, Fremont, 94539 (US); ABDELMONEUM, Mohamed A., Portland, 97229 (US); CARLTON, Brent, Portland, 97229 (US); MANGRULKAR, Kedar, Folsom (US)
(74) Representative: Viering, Jentschura & Partner mbB Patent- und Rechtsanwälte

(57) **Abstract**

An apparatus includes an oscillator circuit and a low-pass filter circuit coupled to an output terminal of the oscillator circuit. The apparatus further includes a first digital signal generator coupled to at least one of an output terminal of the low-pass filter circuit and the output terminal of the oscillator circuit and a second digital signal generator coupled to at least one of the output terminal of the low-pass filter circuit and the output terminal of the oscillator circuit. The second digital signal generator generates a second digital clock signal based on a non-differential signal output of the oscillator circuit. The apparatus further includes a radio frequency interference (RFI) detection circuit coupled to the first digital signal generator and the second digital signal generator. The RFI detection circuit detects RFI associated with the non-differential signal output of the oscillator circuit.

## Description

### TECHNICAL FIELD

Embodiments pertain to reduction of radio frequency interference (RFI) including techniques for the mitigation of RFI on clock circuits.

### BACKGROUND

Computer platforms can get negatively impacted by RF fields (e.g., caused by Wi-Fi and cellphone signals) which can get coupled into the traces and components of the different circuits, causing a degradation in their performance. Specifically, the RF signals coupled into the clock circuitry cause the generated clock signals to get out of operational specifications. As a consequence of the degradation of the clock circuitry performance, related functional issues can appear including display flickering and even spontaneous system crashing and shutdowns. Mitigation of RF interference (RFI) while maintaining power efficiency in computer platforms can be challenging.

### BRIEF DESCRIPTION OF THE DRAWINGS

In the drawings, like numerals may describe the same or similar components or features in different views. Like numerals having different letter suffixes may represent different instances of similar components. Some embodiments are illustrated by way of example, and not limitation, in the figures of the accompanying drawings in which:
FIG. 1 is a block diagram of a radio architecture including an interface card with an RFI mitigation device according to disclosed techniques, in accordance with some embodiments;
FIG. 2 illustrates a front-end module circuitry for use in the radio architecture of FIG. 1, in accordance with some embodiments;
FIG. 3 illustrates a radio IC circuitry for use in the radio architecture of FIG. 1, in accordance with some embodiments;
FIG. 4 illustrates a baseband processing circuitry for use in the radio architecture of FIG. 1, in accordance with some embodiments;
FIG. 5 illustrates a block diagram of an RFI mitigation device including an adaptive clock architecture, in accordance with some embodiments;
FIG. 6 illustrates a block diagram of a duty cycle monitor used by the RFI mitigation device of FIG. 5, in accordance with some embodiments;
FIG. 7 illustrates a block diagram of a jitter monitor used by the RFI mitigation device of FIG. 5, in accordance with some embodiments;
FIG. 8 illustrates a table of example jitter results for a Pierce oscillator with a differential shaper and a single-ended (non-differential) shaper, in accordance with some embodiments;
FIG. 9 illustrates a table of example use cases for applying control signals to enable or disable components of the RFI mitigation device of FIG. 5, in accordance with some embodiments;
FIG. 10 is a flow diagram of an example method for RFI mitigation during clock generation, in accordance with some embodiments; and
FIG. 11 illustrates a block diagram of an example machine upon which any one or more of the operations/techniques (e.g., methodologies) discussed herein may perform.

### DETAILED DESCRIPTION

The following detailed description refers to the accompanying drawings. The same reference numbers may be used in different drawings to identify the same or similar elements. In the following description, for purposes of explanation and not limitation, specific details are set forth such as particular structures, architectures, interfaces, techniques, etc., to provide a thorough understanding of the various aspects of various embodiments. However, it will be apparent to those skilled in the art having the benefit of the present disclosure that the various aspects of the various embodiments may be practiced in other examples that depart from these specific details. In certain instances, descriptions of well-known devices, circuits, and methods are omitted so as not to obscure the description of the various embodiments with unnecessary detail.

The following description and the drawings sufficiently illustrate specific embodiments to enable those skilled in the art to practice them. Other embodiments may incorporate structural, logical, electrical, process, and other changes. Portions and features of some embodiments may be included in or substituted for, those of other embodiments. Embodiments outlined in the claims encompass all available equivalents of those claims.

The term "PMOS transistor" refers to a P-type metal oxide semiconductor field effect transistor. Likewise, "NMOS transistor" refers to an N-type metal oxide semiconductor field effect transistor. It should be appreciated that whenever the terms: "transistor", "MOS transistor", "NMOS transistor", or "PMOS transistor" are used, unless otherwise expressly indicated or dictated by the nature of their use, they are being used in an exemplary manner. They encompass the different varieties of MOS devices including devices with different VTs, materials, insulator thicknesses, and gate(s) configurations, to mention just a few. Moreover, unless specifically referred to as MOS, TFET, CFET, or other, the term transistor can encompass other suitable transistor types, e.g., junction-field-effect transistors, bipolar-junction transistors, metal-semiconductor FETs, and various types of three-dimensional transistors, known today or not yet developed.

The term "channel" refers to a transmission path through which a signal (X(t) in the depicted figure) propagates from a transmitter output to a receiver input. It may include combinations of conductive traces, wireless paths, and/or optical transmission media. For example, it could include combinations of packaging components (e.g., bond wires, solder balls), package traces, sockets, printed-circuit board (PCB) traces, cables (e.g., coaxial, ribbon, twisted pair), wave guides, air (and any other wireless transmission media), optical cable (and other optical transmission components), and so on. It may also include higher-level components for driving, routing, and/or switching signals onto or off of the channel.

As used herein, the term "chip" (or die) refers to a piece of a material, such as a semiconductor material, that includes a circuit such as an integrated circuit or a part of an integrated circuit.

The term memory IP indicates memory intellectual property. The terms memory IP, memory device, memory chip, and memory are interchangeable.

A chipset is an integrated circuit block that has been designed to work with other chipsets to form larger more complex processing modules. In such modules, a system is subdivided into circuit blocks, called "chipsets", that are often made of reusable IP blocks. They typically are formed on a single semiconductor die but may comprise multiple dies or die components. A benefit of employing chipsets to make a processing module is that they may be formed from different process nodes with different associated strengths, costs, etc. In addition, in many cases, it is easier to make smaller chipsets forming a larger, overall processing system rather than implementing the system on a single die.

Some solutions for mitigating the impact of RFI are based on adding shielding materials and absorbers which increases the cost to the overall platform. Other RFI mitigation solutions are based on adding a phase-locked loop (PLL). However, such PLL consumes a significant amount of power and is turned ON constantly, even without the presence of RF fields. The disclosed RFI mitigation techniques reduce the impact of RFI with a minimum increase in power consumption when the RF fields are present using an adaptive architecture that engages mitigation circuity when necessary.

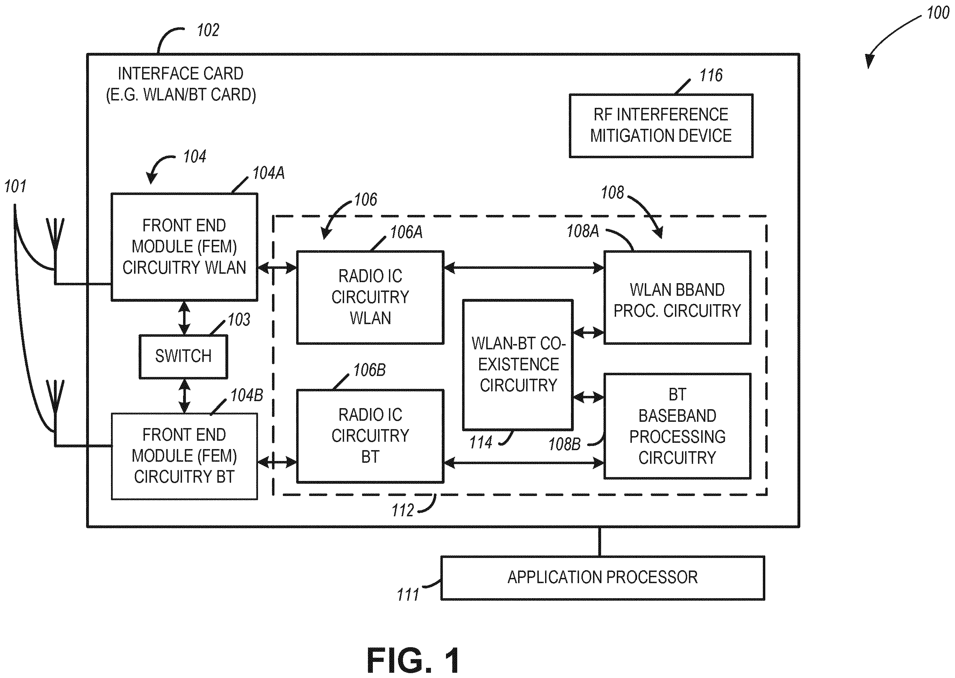

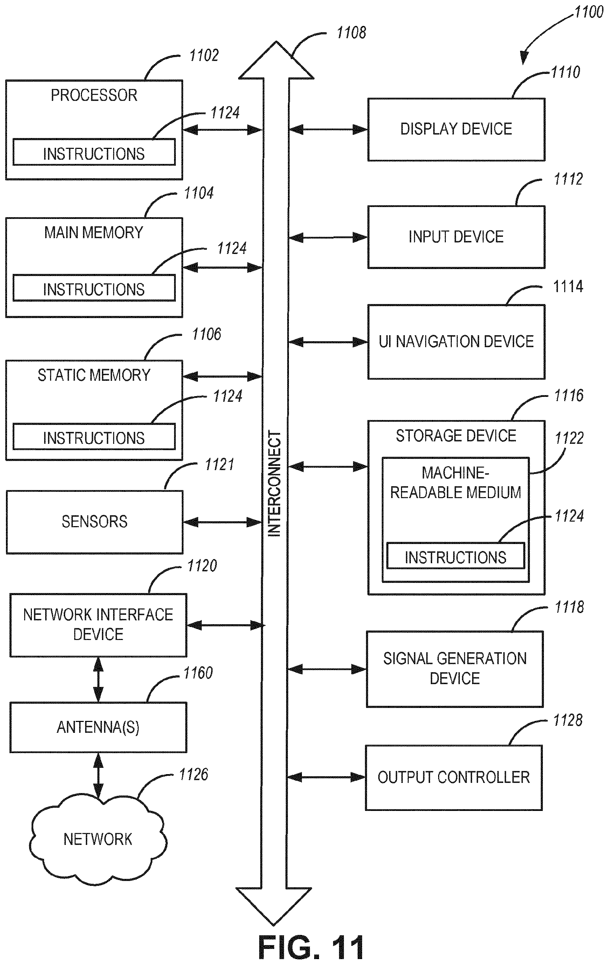

FIG. 1 is a block diagram of a radio architecture 100 including an interface card 102 with an RFI mitigation device 116, in accordance with some embodiments. The radio architecture 100 may be implemented in a computing device (e.g., device 1100 in FIG. 11) including user equipment (UE), a base station (e.g., a next-generation Node-B (gNB), enhanced Node-B (eNB)), a smartphone, a personal computer (PC), a laptop, a tablet, or another type of wired or wireless device. The radio architecture 100 may include radio front-end module (FEM) circuitry 104, radio integrated circuit (IC) circuitry 106, RFI mitigation device 116, and baseband processing circuitry 108 configured as part of the interface card 102. In this regard, radio architecture 100 (as shown in FIG. 1) includes an interface card 102 configured to perform both Wireless Local Area Network (WLAN) functionalities and Bluetooth (BT) functionalities (e.g., as WLAN/BT interface or modem card), although embodiments are not so limited and the disclosed techniques apply to other types of radio architectures with different types of interface cards as well. In this disclosure, "WLAN" and "Wi-Fi" are used interchangeably. Other example types of interface cards which can be used in connection with the disclosed techniques include graphics cards, network cards, SSD cards (such as M.2-based cards), CEM-based cards, etc.

FEM circuitry 104 may include a WLAN or Wi-Fi FEM circuitry 104A and a Bluetooth (BT) FEM circuitry 104B. The WLAN FEM circuitry 104A may include a receive signal path comprising circuitry configured to operate on WLAN RF signals received from one or more antennas 101, to amplify the received signals, and provide the amplified versions of the received signals to the WLAN radio IC circuitry 106A for further processing. The BT FEM circuitry 104B may include a receive signal path which may include circuitry configured to operate on BT RF signals received from the one or more antennas 101, to amplify the received signals, and provide the amplified versions of the received signals to the BT radio IC circuitry 106B for further processing. The WLAN FEM circuitry 104A may also include a transmit signal path which may include circuitry configured to amplify WLAN signals provided by the radio IC circuitry 106A for wireless transmission by the one or more antennas 101. Besides, the BT FEM circuitry 104B may also include a transmit signal path which may include circuitry configured to amplify BT signals provided by the radio IC circuitry 106B for wireless transmission by the one or more antennas. In the embodiment of FIG. 1, although WLAN FEM circuitry 104A and BT FEM circuitry 104B are shown as being distinct from one another, embodiments are not so limited and include within their scope the use of a FEM (not shown) that includes a transmit path and/or a receive path for both WLAN and BT signals or the use of one or more FEM circuitries where at least some of the FEM circuitries share transmit and/or receive signal paths for both WLAN and BT signals.

Radio IC circuitry 106 as shown may include WLAN radio IC circuitry 106A and BT radio IC circuitry 106B. The WLAN radio IC circuitry 106A may include a receive signal path which may include circuitry to down-convert WLAN RF signals received from the WLAN FEM circuitry 104A and provide baseband signals to WLAN baseband processing circuitry 108A. The BT radio IC circuitry 106B may, in turn, include a receive signal path which may include circuitry to down-convert BT RF signals received from the BT FEM circuitry 104B and provide baseband signals to BT baseband processing circuitry 108B. The WLAN radio IC circuitry 106A may also include a transmit signal path which may include circuitry to up-convert WLAN baseband signals provided by the WLAN baseband processing circuitry 108A and provide WLAN RF output signals to the WLAN FEM circuitry 104A for subsequent wireless transmission by the one or more antennas 101. The BT radio IC circuitry 106B may also include a transmit signal path which may include circuitry to up-convert BT baseband signals provided by the BT baseband processing circuitry 108B and provide BT RF output signals to the BT FEM circuitry 104B for subsequent wireless transmission by the one or more antennas 101. In the embodiment of FIG. 1, although radio IC circuitries 106A and 106B are shown as being distinct from one another, embodiments are not so limited and include within their scope the use of a radio IC circuitry (not shown) that includes a transmit signal path and/or a receive signal path for both WLAN and BT signals, or the use of one or more radio IC circuitries where at least some of the radio IC circuitries share transmit and/or receive signal paths for both WLAN and BT signals.

Baseband processing circuitry 108 may include a WLAN baseband processing circuitry 108A and a BT baseband processing circuitry 108B. The WLAN baseband processing circuitry 108A may include a memory, such as, for example, a set of RAM arrays in a Fast Fourier Transform (FFT) or Inverse Fast Fourier Transform (IFFT) block (not shown) of the WLAN baseband processing circuitry 108A. Each of the WLAN baseband processing circuitry 108A and the BT baseband processing circuitry 108B may further include one or more processors and control logic to process the signals received from the corresponding WLAN or BT receive signal path of the radio IC circuitry 106, and to also generate corresponding WLAN or BT baseband signals for the transmit signal path of the radio IC circuitry 106. Each of the baseband processing circuitries 108A and 108B may further include a physical layer (PHY) and medium access control layer (MAC) circuitry and may further interface with a host processor (e.g., the application processor 111) in a host system (e.g., a host SoC) for generation and processing of the baseband signals and for controlling operations of the radio IC circuitry 106 (including controlling the operation of the RFI mitigation device 116).

Referring still to FIG. 1, according to the shown embodiment, WLAN-BT coexistence circuitry 114 may include logic providing an interface between the WLAN baseband processing circuitry 108A and the BT baseband processing circuitry 108B to enable use cases requiring WLAN and BT coexistence. In addition, a switch 103 may be provided between the WLAN FEM circuitry 104A and the BT FEM circuitry 104B to allow switching between the WLAN and BT radios according to application needs. In addition, although the one or more antennas 101 are depicted as being respectively connected to the WLAN FEM circuitry 104A and the BT FEM circuitry 104B, embodiments include within their scope the sharing of the one or more antennas 101 as between the WLAN and BT FEMs, or the provision of more than one antenna connected to each of FEM circuitries 104A or 104B.

In some embodiments, the front-end module circuitry 104, the radio IC circuitry 106, and the baseband processing circuitry 108 may be provided on a single radio card, such as the interface card 102. In some other embodiments, the one or more antennas 101, the FEM circuitry 104, and the radio IC circuitry 106 may be provided on a single radio card. In some other embodiments, the radio IC circuitry 106 and the baseband processing circuitry 108 may be provided on a single chip or IC, such as IC 112.

In some embodiments, the interface card 102 can be configured as a wireless radio card, such as a WLAN radio card configured for wireless communications (e.g., WiGig communications in the 60 GHz range or mmW communications in the 24.24 GHz - 52.6 GHz range), although the scope of the embodiments is not limited in this respect. In some of these embodiments, the radio architecture 100 may be configured to receive and transmit orthogonal frequency division multiplexed (OFDM) or orthogonal frequency division multiple access (OFDMA) communication signals over a multicarrier communication channel. The OFDM or OFDMA signals may comprise a plurality of orthogonal subcarriers.

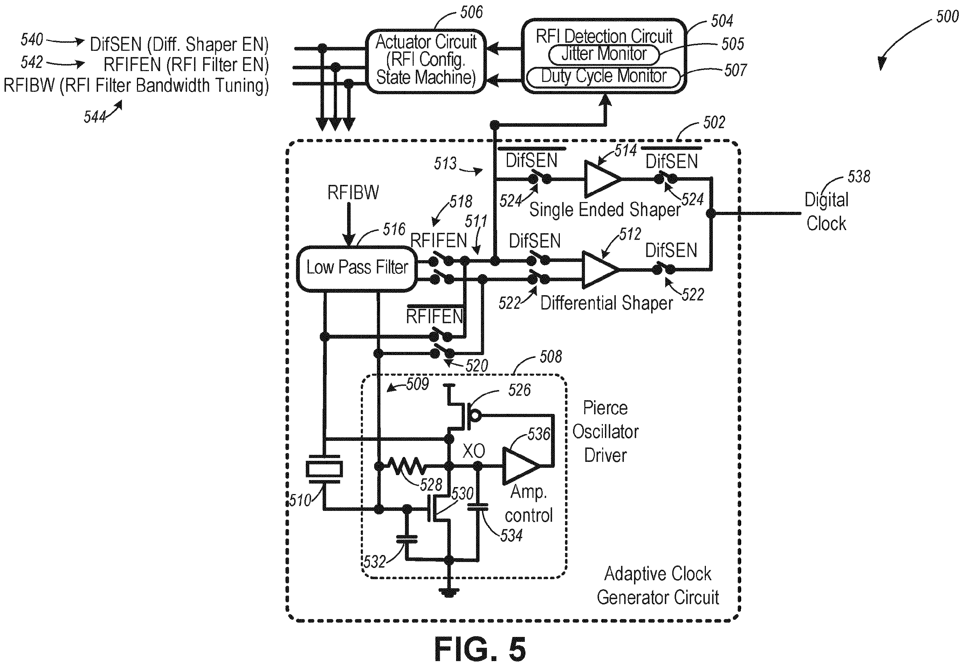

In some embodiments, the interface card 102 may include RFI mitigation device 116, which can be configured to reduce RFI based on the disclosed techniques. In this regard, RFI mitigation device 116 can be the same as, or include, the RFI mitigation devices discussed in connection with FIGS. 5-11. Configuring the RFI mitigation device 116 (or any of its components discussed herein) can be based on one or more of the techniques discussed in connection with FIGS. 5-11.

In some aspects, the RFI mitigation device 116 is configured to mitigate RFI in connection with clock generation circuitry (e.g., synthesizer circuitry 304 in radio IC circuitry 300) or any other type of circuitry experiencing RFI. Even though FIG. 1 illustrates the RFI mitigation device 116 as implemented within an interface card 102, the present disclosure is not limited in this regard and the RFI mitigation device 116 can be implemented as part of other circuits or as a stand-alone device in a computer system or a computing device (e.g., computing device 1100 of FIG. 11). For example, the disclosed RFI mitigation circuitry can be used as clocking circuity that is part of a radio module (e.g., as illustrated in FIG. 1), as clocking circuitry generating clock signals affected by RFI from a radio transmitter (Wi-Fi or cellular) integrated in the same computing system (e.g., as circuitry that can connect to a motherboard through an interface or it is part of the same motherboard), or as clocking circuitry generating clock signals affected by RFI from a radio transmitter that is not part of the system.

In some of these multicarrier embodiments, radio architecture 100 may be a part of a Wi-Fi communication station (STA) such as a wireless access point (AP), a base station, or a mobile device including a Wi-Fi-enabled device. In some of these embodiments, radio architecture 100 may be configured to transmit and receive signals in accordance with specific communication standards and/or protocols, such as any of the Institute of Electrical and Electronics Engineers (IEEE) standards including, 802.11n-2009, IEEE 802.11-2012, 802.11n-2009, 802.11ac, IEEE 802.11-2016, 802.11ad, and/or 802.11ax standards and/or proposed specifications for WLANs, although the scope of embodiments is not limited in this respect and operations using other wireless standards can also be configured. Radio architecture 100 may also be suitable to transmit and/or receive communications in accordance with other techniques and standards, including a 3rd Generation Partnership Project (3GPP) standard, including a communication standard used in connection with 5G or new radio (NR) communications.

In some embodiments, the radio architecture 100 may be configured for high-efficiency (HE) Wi-Fi communications in accordance with the IEEE 802.11ax standard or another standard associated with wireless communications. In these embodiments, the radio architecture 100 may be configured to communicate in accordance with an OFDMA technique, although the scope of the embodiments is not limited in this respect.

In some other embodiments, the radio architecture 100 may be configured to transmit and receive signals transmitted using one or more other modulation techniques such as spread spectrum modulation (e.g., direct sequence code division multiple access (DS-CDMA) and/or frequency hopping code division multiple access (FH-CDMA)), time-division multiplexing (TDM) modulation, and/or frequency-division multiplexing (FDM) modulation, although the scope of the embodiments is not limited in this respect.

In some embodiments, as further shown in FIG. 1, the BT baseband processing circuitry 108B may be compliant with a Bluetooth (BT) connectivity standard such as Bluetooth, Bluetooth 4.0 or Bluetooth 5.0, or any other iteration of the Bluetooth Standard. In embodiments that include BT functionality as shown for example in FIG. 1, the radio architecture 100 may be configured to establish a BT synchronous connection-oriented (SCO) link and or a BT low energy (BT LE) link. In some of the embodiments that include functionality, the radio architecture 100 may be configured to establish an extended SCO (eSCO) link for BT communications, although the scope of the embodiments is not limited in this respect. In some of these embodiments that include a BT functionality, the radio architecture may be configured to engage in a BT Asynchronous Connection-Less (ACL) communications, although the scope of the embodiments is not limited in this respect. In some embodiments, as shown in FIG. 1, the functions of a BT radio card and WLAN radio card may be combined on a single wireless radio card, such as the interface card 102, although embodiments are not so limited, and include within their scope discrete WLAN and BT radio cards.

In some embodiments, the radio architecture 100 may include other radio cards, such as a cellular radio card configured for cellular/wireless communications (e.g., 3GPP such as LTE, LTE-Advanced, WiGig, or 5G communications including mmW communications), which may be implemented together with (or as part of) the interface card 102.

In some IEEE 802.11 embodiments, the radio architecture 100 may be configured for communication over various channel bandwidths including bandwidths having center frequencies of about 900 MHz, 2.4 GHz, 5 GHz, and bandwidths of about 1 MHz, 2 MHz, 2.5 MHz, 4 MHz, 5 MHz, 8 MHz, 10 MHz, 16 MHz, 20 MHz, 40 MHz, 80 MHz (with contiguous bandwidths) or 80+80 MHz (160 MHz) (with non-contiguous bandwidths). In some embodiments, a 320 MHz channel bandwidth may be used. The scope of the embodiments is not limited with respect to the above center frequencies, however.

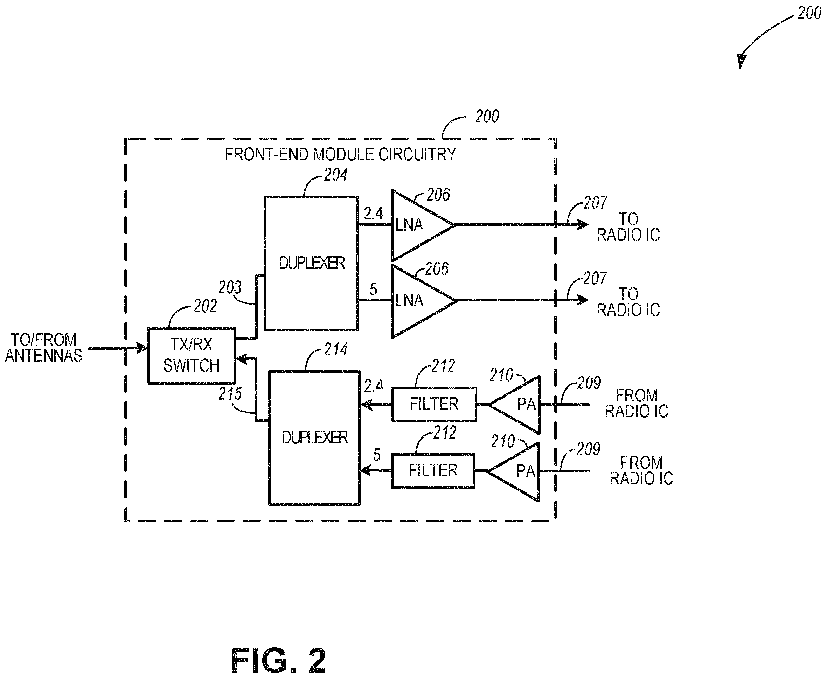

FIG. 2 illustrates FEM circuitry 200 in accordance with some embodiments. The FEM circuitry 200 is one example of circuitry that may be suitable for use as the WLAN and/or BT FEM circuitry 104A/104B (FIG. 1), although other circuitry configurations may also be suitable.

In some embodiments, the FEM circuitry 200 may include a TX/RX switch 202 to switch between transmit (TX) mode and receive (RX) mode operation. In some aspects, a diplexer may be used in place of a TX/RX switch. The FEM circuitry 200 may include a receive signal path and a transmit signal path. The receive signal path of the FEM circuitry 200 may include a low-noise amplifier (LNA) 206 to amplify received RF signals 203 and provide the amplified received RF signals 207 as an output (e.g., to the radio IC circuitry 106 (FIG. 1)). The transmit signal path of the FEM circuitry 200 may include a power amplifier (PA) to amplify input RF signals 209 (e.g., provided by the radio IC circuitry 106), and one or more filters 212, such as band-pass filters (BPFs), low-pass filters (LPFs) or other types of filters, to generate RF signals 215 for subsequent transmission (e.g., by the one or more antennas 101 (FIG. 1)).

In some dual-mode embodiments for Wi-Fi communication, the FEM circuitry 200 may be configured to operate in, e.g., either the 2.4 GHz frequency spectrum or the 5 GHz frequency spectrum. In these embodiments, the receive signal path of the FEM circuitry 200 may include a receive signal path duplexer 204 to separate the signals from each spectrum as well as provide a separate LNA 206 for each spectrum as shown. In these embodiments, the transmit signal path of the FEM circuitry 200 may also include a power amplifier (PA) 210 and one or more filters 212, such as a BPF, an LPF, or another type of filter for each frequency spectrum, and a transmit signal path duplexer 214 to provide the signals of one of the different spectrums onto a single transmit path for subsequent transmission by the one or more antennas 101 (FIG. 1). In some embodiments, BT communications may utilize the 2.4 GHz signal path and may utilize the same FEM circuitry 200 as the one used for WLAN communications.

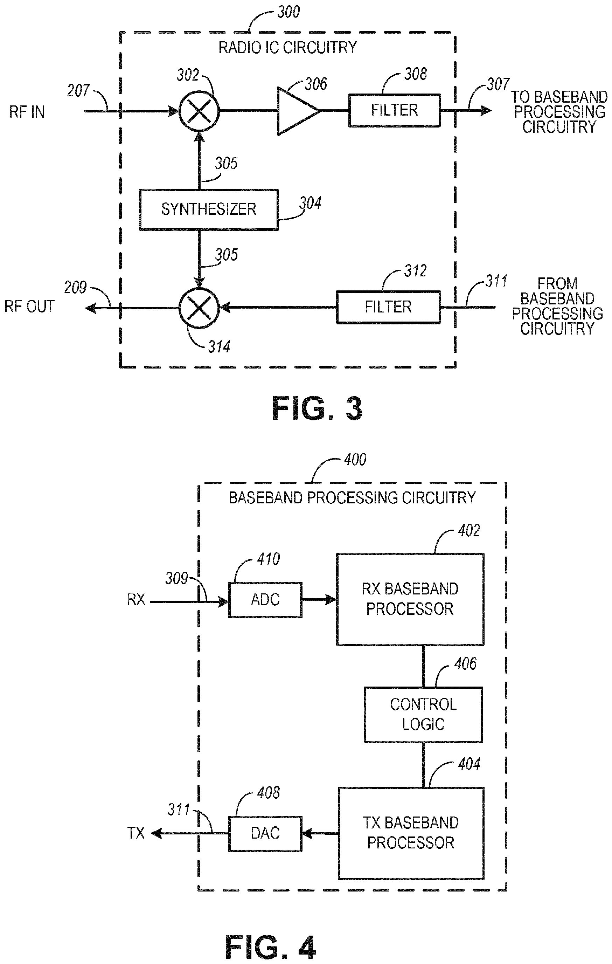

FIG. 3 illustrates radio IC circuitry 300 in accordance with some embodiments. The radio IC circuitry 300 is one example of circuitry that may be suitable for use as the WLAN or BT radio IC circuitry 106A/106B (FIG. 1), although other circuitry configurations may also be suitable.

In some embodiments, the radio IC circuitry 300 may include a receive signal path and a transmit signal path. The receive signal path of the radio IC circuitry 300 may include mixer circuitry 302, such as, for example, down-conversion mixer circuitry, amplifier circuitry 306, and filter circuitry 308. The transmit signal path of the radio IC circuitry 300 may include at least filter circuitry 312 and mixer circuitry 314, such as up-conversion mixer circuitry. Radio IC circuitry 300 may also include synthesizer circuitry 304 for synthesizing a frequency 305 for use by the mixer circuitry 302 and the mixer circuitry 314. The mixer circuitry 302 and/or 314 may each, according to some embodiments, be configured to provide direct conversion functionality. The latter type of circuitry presents a much simpler architecture as compared with standard super-heterodyne mixer circuitries, and any flicker noise brought about by the same may be alleviated for example through the use of OFDM modulation. FIG. 3 illustrates only a simplified version of a radio IC circuitry and may include, although not shown, embodiments where each of the depicted circuitries may include more than one component. For instance, mixer circuitry 302 and/or 314 may each include one or more mixers, and filter circuitries 308 and/or 312 may each include one or more filters, such as one or more BPFs and/or LPFs according to application needs. For example, when mixer circuitries are of the direct-conversion type, they may each include two or more mixers.

In some embodiments, mixer circuitry 302 may be configured to down-convert RF signals 207 received from the FEM circuitry 104 (FIG. 1) based on the synthesized frequency 305 provided by the synthesizer circuitry 304. The amplifier circuitry 306 may be configured to amplify the down-converted signals and the filter circuitry 308 may include an LPF configured to remove unwanted signals from the down-converted signals to generate output baseband signals 307. Output baseband signals 307 may be provided to the baseband processing circuitry 108 (FIG. 1) for further processing. In some embodiments, the output baseband signals 307 may be zero-frequency baseband signals, although this is not a requirement. In some embodiments, mixer circuitry 302 may comprise passive mixers, although the scope of the embodiments is not limited in this respect.

In some embodiments, the mixer circuitry 314 may be configured to up-convert input baseband signals 311 based on the synthesized frequency 305 provided by the synthesizer circuitry 304 to generate RF output signals 209 for the FEM circuitry 104. The baseband signals 311 may be provided by the baseband processing circuitry 108 and may be filtered by filter circuitry 312. The filter circuitry 312 may include an LPF or a BPF, although the scope of the embodiments is not limited in this respect.

In some embodiments, the mixer circuitry 302 and the mixer circuitry 314 may each include two or more mixers and may be arranged for quadrature down-conversion and/or up-conversion respectively with the help of the synthesizer circuitry 304. In some embodiments, the mixer circuitry 302 and the mixer circuitry 314 may each include two or more mixers each configured for image rejection (e.g., Hartley image rejection). In some embodiments, the mixer circuitry 302 and the mixer circuitry 314 may be arranged for direct down-conversion and/or direct up-conversion, respectively. In some embodiments, the mixer circuitry 302 and the mixer circuitry 314 may be configured for super-heterodyne operation, although this is not a requirement.

Mixer circuitry 302 may comprise, according to one embodiment: quadrature passive mixers (e.g., for the in-phase (I) and quadrature-phase (Q) paths). In such an embodiment, RF input signal 207 from FIG. 2 may be down-converted to provide I and Q baseband output signals to be sent to the baseband processor.

Quadrature passive mixers may be driven by zero and ninety-degree time-varying LO switching signals provided by a quadrature circuitry which may be configured to receive a LO frequency (fLO) from a local oscillator or a synthesizer, such as LO frequency 305 of synthesizer circuitry 304 (FIG. 3). In some embodiments, the LO frequency may be the carrier frequency, while in other embodiments, the LO frequency may be a fraction of the carrier frequency (e.g., one-half the carrier frequency, one-third the carrier frequency). In some embodiments, the zero and ninety-degree time-varying switching signals may be generated by the synthesizer, although the scope of the embodiments is not limited in this respect.

In some embodiments, the LO signals may differ in the duty cycle (the percentage of one period in which the LO signal is high) and/or offset (the difference between the start points of the period). In some embodiments, the LO signals may have a 25% duty cycle and a 50% offset. In some embodiments, each branch of the mixer circuitry (e.g., the in-phase (I) and quadrature-phase (Q) path) may operate at a 25% duty cycle, which may result in a significant reduction in power consumption.

The RF input signal 207 (FIG. 2) may comprise a balanced signal, although the scope of the embodiments is not limited in this respect. The I and Q baseband output signals may be provided to the low-noise amplifier, such as amplifier circuitry 306 (FIG. 3) or filter circuitry 308 (FIG. 3).

In some embodiments, the output baseband signals 307 and the input baseband signals 311 may be analog, although the scope of the embodiments is not limited in this respect. In some alternate embodiments, the output baseband signals 307 and the input baseband signals 311 may be digital. In these alternate embodiments, the radio IC circuitry may include an analog-to-digital converter (ADC) and digital-to-analog converter (DAC) circuitry.

In some dual-mode embodiments, a separate radio IC circuitry may be provided for processing signals for each spectrum, or for other spectrums not mentioned here, although the scope of the embodiments is not limited in this respect.

In some embodiments, the synthesizer circuitry 304 may be a fractional-N synthesizer or a fractional N/N+1 synthesizer, although the scope of the embodiments is not limited in this respect as other types of frequency synthesizers may be suitable. In some embodiments, the synthesizer circuitry 304 may be a delta-sigma synthesizer, a frequency multiplier, or a synthesizer comprising a phase-locked loop with a frequency divider. According to some embodiments, the synthesizer circuitry 304 may include a digital frequency synthesizer circuitry. An advantage of using a digital synthesizer circuitry is that, although it may still include some analog components, its footprint may be scaled down much more than the footprint of an analog synthesizer circuitry. In some embodiments, frequency input into synthesizer circuitry 304 may be provided by a voltage-controlled oscillator (VCO), although that is not a requirement. A divider control input may further be provided by either the baseband processing circuitry 108 (FIG. 1) or the host processor 111 (FIG. 1) depending on the desired output frequency 305. In some embodiments, a divider control input (e.g., N) may be determined from a look-up table (e.g., within a Wi-Fi card) based on a channel number and a channel center frequency as determined or indicated by the host processor 111.

In some embodiments, synthesizer circuitry 304 may be configured to generate a carrier frequency as the output frequency 305, while in other embodiments, the output frequency 305 may be a fraction of the carrier frequency (e.g., one-half of the carrier frequency, one-third of the carrier frequency). In some embodiments, the output frequency 305 may be an LO frequency (fLO).

FIG. 4 illustrates a baseband processing circuitry 400 for use in the radio architecture of FIG. 1, in accordance with some embodiments. The baseband processing circuitry 400 is one example of circuitry that may be suitable for use as the baseband processing circuitry 108 (FIG. 1), although other circuitry configurations may also be suitable. The baseband processing circuitry 400 may include a receive baseband processor (RX BBP) 402 for processing receive baseband signals 309 provided by the radio IC circuitry 106 (FIG. 1) and a transmit baseband processor (TX BBP) 404 for generating transmit baseband signals 311 for the radio IC circuitry 106. The baseband processing circuitry 400 may also include control logic 406 for coordinating the operations of the baseband processing circuitry 400.

In some embodiments (e.g., when analog baseband signals are exchanged between the baseband processing circuitry 400 and the radio IC circuitry 106), the baseband processing circuitry 400 may include an analog-to-digital converter (ADC) 410 to convert analog baseband signals 309 received from the radio IC circuitry 106 to digital baseband signals for processing by the RX BBP 402. In these embodiments, the baseband processing circuitry 400 may also include a digital-to-analog converter (DAC) 408 to convert digital baseband signals from the TX BBP 404 to analog baseband signals 311.

In some embodiments that communicate OFDM signals or OFDMA signals, such as through the WLAN baseband processing circuitry 108A, the TX BBP 404 may be configured to generate OFDM or OFDMA signals as appropriate for transmission by performing an inverse fast Fourier transform (IFFT). The RX BBP 402 may be configured to process received OFDM signals or OFDMA signals by performing an FFT. In some embodiments, the RX BBP 402 may be configured to detect the presence of an OFDM signal or OFDMA signal by performing an autocorrelation, to detect a preamble, such as a short preamble, and performing a cross-correlation, to detect a long preamble. The preambles may be part of a predetermined frame structure for Wi-Fi communication.

Referring back to FIG. 1, in some embodiments, the one or more antennas 101 (FIG. 1) may each comprise one or more directional or omnidirectional antennas, including, for example, dipole antennas, monopole antennas, patch antennas, loop antennas, microstrip antennas or other types of antennas suitable for transmission of RF signals. In some multiple-input multiple-output (MIMO) embodiments, the antennas may be effectively separated to take advantage of spatial diversity and the different channel characteristics that may result. The one or more antennas 101 may each include a set of phased-array antennas, although embodiments are not so limited.

Although the radio architecture 100 is illustrated as having several separate functional elements, one or more of the functional elements may be combined and may be implemented by combinations of software-configured elements, such as processing elements including digital signal processors (DSPs), and/or other hardware elements. For example, some elements may comprise one or more microprocessors, DSPs, field-programmable gate arrays (FPGAs), application-specific integrated circuits (ASICs), radio-frequency integrated circuits (RFICs), and combinations of various hardware and logic circuitry for performing at least the functions described herein. In some embodiments, the functional elements may refer to one or more processes operating on one or more processing elements.

The performance of clocks can severely be affected by RF signals generated from nearby devices such as cellphones. These high-frequency signals can get coupled into a signal path causing a significant increase in jitter, causing digital devices to fail.

In some aspects (e.g., as discussed in connection with FIGS. 5-11), the disclosed techniques include configuring an RFI mitigation device to mitigate RFI using an adaptive architecture. Some techniques for reducing RFI in clock circuitry include passive methods such as shielding and routing clock traces in PCB internal layers. Other techniques including passive filtering to reduce the impact of high-frequency RF can be added to the circuit design path. Additionally, PLLs and similar architectures can also be added to the circuit path to perform filtering, re-clocking, jitter cleaning, and so forth.

However, the above-listed solutions are associated with the following drawbacks. Shielding adds cost to the overall product and also constrains the product to have a certain clearance limiting the thickness of a device such as a laptop. Adding extra layers for routing also adds cost and given the complex design of a computer system, the traces might not be able to be routed in internal layers. Passive filtering cannot entirely mitigate the effect of the RFI due to the limited attenuation that provides in the stopbands, and it also cannot attenuate the interferers and any intermodulation product close to the main clock frequency. Additionally, filtering adds noise to the overall circuit performance. PLLs and any other related architectures are power-hungry in relationship with the clock circuitry, it also adds complexity to the design.

The RFI mitigation techniques discussed herein can be based on monitoring the jitter and the duty cycle at the output of the oscillator driver for any sign that RFI might be present in the circuitry. For example, any significant increase in jitter and/or the duty cycle (e.g., at levels above a threshold) that are out of spec can be a sign that RFI has been coupled and is present. Whenever RFI is detected, different parts of the circuitry that mitigates RFI are engaged avoiding that the system performance gets compromised. The disclosed mitigation circuitry is a novel, low-power solution that takes advantage of the nature of the interference to perform on par with more power-hungry solutions (e.g., using a PLL). The disclosed RFI mitigation techniques can result in avoiding extra production costs such as extra shielding and/or the need for routing solutions that increase the cost of a PCB. The proposed solution has a lower power consumption than existing RFI mitigation techniques which results in longer battery time in laptops for example. Moreover, in the absence of RFI, the clock will provide the most optimum performance since the disclosed RFI filtering circuitry can be fully turned OFF.

In some aspects, the RF noise induced in the traces that connect the resonator (e.g., quartz crystal) to the oscillator circuit can be decomposed in common mode and differential mode. The induced RF noise can be dominated by common mode as can be validated trough analysis of simulations and experimental data of common clock routings found in computing platforms.

FIG. 5 illustrates a block diagram of a RFI mitigation device 500 including an adaptive clock architecture, in accordance with some embodiments. Referring to FIG. 5, the RFI mitigation device 500 includes an adaptive clock generator circuit 502, an RFI detection circuit 504, and an actuator circuit 506. Even though FIG. 5 illustrates the adaptive clock generator circuit 502, the RFI detection circuit 504, and the actuator circuit 506 as three separate circuits, the disclosure is not limited in this regard and two or more of these circuits can be implemented as a single circuit.

The adaptive clock generator circuit 502 comprises a low-pass filter circuit 516, an oscillator circuit 508, a first digital signal generator 512, a second digital signal generator 514, and switches 518, 520, 522, and 524.

The oscillator circuit 508 includes a crystal 510, resistor 528, capacitors 534 and 534, transistors 526 and 539, and amplifier 536. In some embodiments, the oscillator circuit 508 is configured as a Pierce oscillator generating sinusoidal signal 509.

The low-pass filter circuit 516 is configured to receive the sinusoidal signal 509 (which can be generated as a differential signal) and output a filtered sinusoidal differential signal 511, which is received by the first digital signal generator 512. A non-differential signal 513, which is based on the filtered sinusoidal differential signal 511, is received by the second digital generator 514 and the RFI detection circuit 504.

The first digital signal generator 512 is configured to receive the filtered sinusoidal differential signal 511 from an output terminal of the low-pass filter circuit 516 via switches 518 and 522 (e.g. when the switches are activated). The first digital signal generator 512 is also configured to receive the sinusoidal signal 509 via switches 520 and 522 (e.g., when the switches are activated). The first digital signal generator 512 is configured to generate a digital signal (output as digital clock signal 538) based on the sinusoidal signal 509 or the filtered sinusoidal differential signal 511.

The second digital signal generator 514 is configured to receive the non-differential signal 513 (which can be based on the filtered sinusoidal differential signal 511) via switch 524 (e.g. when switch 524 is enabled). The second digital signal generator 514 is configured to generate a digital signal (output as digital clock signal 538) based on the non-differential signal 513.

In some embodiments, the first digital signal generator 512 is configured as a differential shaper circuit, and the second digital signal generator 514 is configured as a single-ended shaper circuit.

The RFI detection circuit 504 is coupled to the first digital signal generator 512 and the second digital signal generator 514 via corresponding switches 522 and 524. The RFI detection circuit 504 comprises a jitter monitor 505 and a duty cycle monitor 507 and is configured to receive the non-differential signal 513. The jitter monitor 505 is configured to determine the jitter level associated with the non-differential signal 513. The duty cycle monitor 507 is configured to determine the duty cycle level associated with the non-differential signal 513. The RFI detection circuit is to detect the presence of RFI associated with the non-differential signal 513 output by the oscillator circuit 508 based on one or both of the jitter level or the duty cycle level. For example, RFI can be considered present when the jitter level is above a first threshold or the duty cycle level is above a second threshold.

The actuator circuit 506 is coupled to the RFI detection circuit 504 and is to generate one or more control signals (e.g., control signals 540, 542, and 544) based on the RFI detected by the RFI detection circuit 504. In some aspects, the actuator circuit is to enable at least one of the low-pass filter circuit 516 (e.g., based on a state machine), the first digital signal generator 512, and the second digital signal generator 514 based on the one or more control signals.

For example, control signal 540 is a differential shaper enable signal (also referred to as DifSEN) which enables (or disables) the first digital signal generator 512 (or the differential shaper) by enabling (or disabling) switch 522 and disabling (or enabling) the complementary switch 524 (which disconnects the second digital signal generator 514, or the single-ended shaper).

Control signal 542 is an RFI filter enable signal (also referred to as RFIFEN) which enables (or disables) the low-pass filter circuit 516 by enabling (or disabling) switch 518 and disabling (or enabling) the complementary switch 520. The complementary relation of switches 518-520 and 522-524 is indicated in FIG. 5.

Control signal 544 is an RFI filter bandwidth tuning signal (also referred to as RFIBW) that can be used to configure the tuning bandwidth of the low-pass filter circuit 516.

In some aspects, when the RFI is equal to or is above a first threshold, the one or more control signals enable the low-pass filter circuit 516 and the first digital signal generator 512 and disable the second digital signal generator 514.

In some aspects, when the RFI is equal to or is above a first threshold and the power consumption level of the apparatus that the digital clock signal 538 is supplied to is above a second threshold, the one or more control signals enable the low-pass filter circuit 516 and the second digital signal generator 514 and disable the first digital signal generator 512.

In some aspects, when the RFI is below the first threshold, the one or more control signals disable the low-pass filter circuit 516 and the first digital signal generator 512 and enable the second digital signal generator 514.

In some aspects, the RFI detection circuit 504 further detects a frequency of the RFI. Control signal 544 (RFIFBW) can be used for filter bandwidth tuning of the low-pass filter circuit 516 based on the frequency of the RFI.

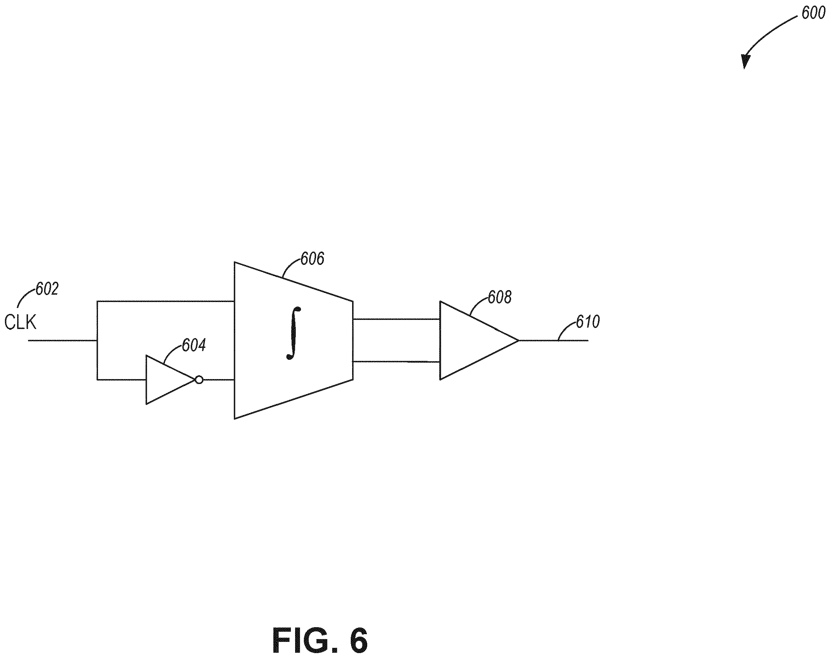

FIG. 6 illustrates a block diagram of a duty cycle monitor 600 used by the RFI mitigation device of FIG. 5, in accordance with some embodiments. For example, duty cycle monitor 600 can be the same as duty cycle monitor 507.

In some aspects, the duty cycle monitor 600 includes an inverter 604, an integrator 606, and a comparator 608. The inverter 604 and the integrator 606 receive the input clock signal 602, and the comparator 608 generates an output signal 610 indicative of a delay between the current clock signal and a delayed clock signal as a measure of the clock signal duty cycle.

In some aspects, duty cycle monitor 600 compares the high part and the low part of the input clock signal 602 to establish if the duty cycle has changed sending a trigger to the actuator circuit 506.

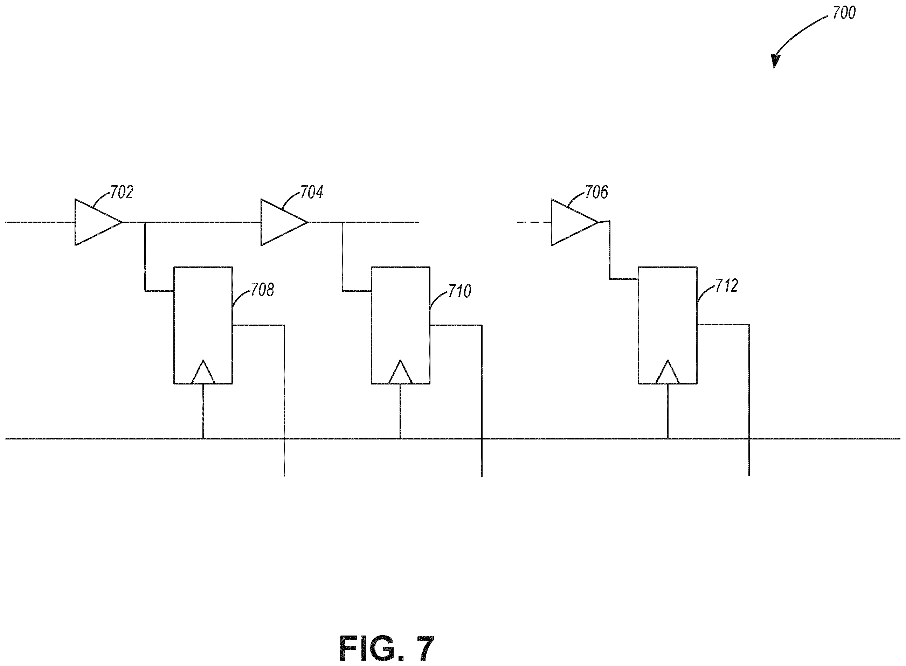

FIG. 7 illustrates a block diagram of a jitter monitor 700 used by the RFI mitigation device of FIG. 5, in accordance with some embodiments. The jitter monitor 700 can be the same as jitter monitor 505 of FIG. 5. In some aspects, the jitter monitor 700 can be implemented using time-to-digital converters (TDCs) that are used to compare the current period of the clock with the base clock for estimating the jitter. An example TDC used for jitter monitoring is shown in FIG. 7.

In some aspects, jitter monitor 700 includes a plurality of delay circuits 702, 704, ..., 706 coupled to a corresponding plurality of flip-flop circuits 708, 710, ..., 712.

As illustrated in FIG. 5, the proposed RFI mitigation device includes an adaptive clock generator circuit 502 including an oscillator circuit 508 (e.g., a Pierce oscillator) that generates a sinusoidal waveform from a resonator. A shaper converts the sinusoidal waveform into a square waveform either using a single-ended topology (e.g., the second digital signal generator 514) when RFI is not present or the low-pass filter circuit 516 plus a differential topology (e.g., the first digital signal generator 512) when RFI is present. The RFI detection circuit 504 and the actuator circuit 506 will track the output of the oscillator for any significant increase in jitter or any change in the duty cycle to enable or disable different parts of the adaptive clock generator circuit 502.

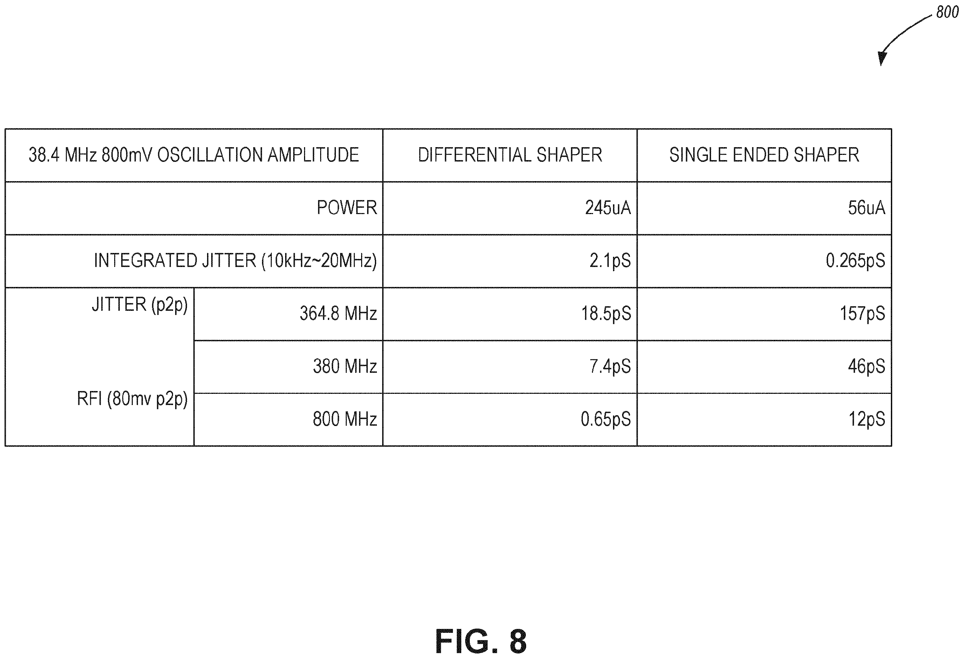

In some aspects, two circuit topologies are present in the clock section of the architecture. One that resembles a regular Pierce oscillator where a single-ended shaper is used to generate the output clock. The other section uses instead a tunable low-pass filter and a differential shaper. The latter one is an RFI mitigation topology that can be used to effectively mitigate the common mode-induced voltage caused by the RF fields coupled into traces, improving the jitter performance significantly (e.g., as illustrated in table 800 of FIG. 8).

The addition of the filter and the differential shaper in the signal path adds some noise and there is an increase in power consumption (e.g., as seen in table 800) hence the approach of an adaptive architecture that utilizes the mitigation topology only when it is needed.

In some aspects, the adaptive control is done by monitoring the output of the clock generator for jitter and duty cycle significant changes that are due to RF presence. When the presence of RF interference is confirmed the RF topology will be enabled. On-die jitter and duty-cycle monitors, which are typically present in a system can be leveraged. This usually takes at least a cycle to decide that the clock circuitry has been compromised.

In some aspects, the duty cycle monitor 507 requires at least one cycle to establish if a change has occurred. For the jitter monitor 505, the total number of cycles will depend on the resolution that is needed to establish that the jitter is caused by RFI and the amount of jitter that can be tolerated. This will add a few cycles before the RFI state machine of the actuator circuit 506 can decide if the differential shaper needs to be engaged.

FIG. 8 illustrates Table 800 of example jitter results for a Pierce oscillator with a differential shaper and a single-ended (non-differential) shaper, in accordance with some embodiments. More specifically, Table 800 compares the performance of the crystal oscillator with the presence of 80mVpp RFI showing the improvements in jitter in differential shaper compared to single-ended shaper. As seen in FIG. 8, jitter is mitigated using the disclosed techniques.

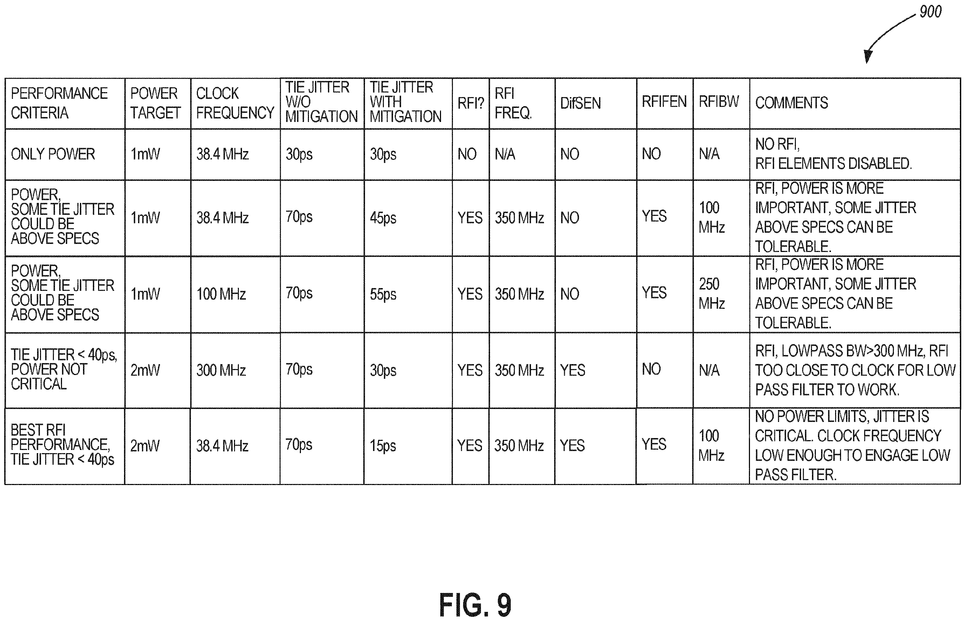

FIG. 9 illustrates Table 900 of example use cases for applying control signals to enable or disable components of the RFI mitigation device of FIG. 5, in accordance with some embodiments. In some aspects, the following example configurations and the configurations illustrated in Table 900 can be used by a state machine of the actuator circuit 506 to determine which of the control signals 540-544 to activate or deactivate.

The presence of RF in the clock circuity produces an increase of jitter and/or change in the duty cycle of the square waveform. Each clock has defined specs for jitter and duty cycle that might vary depending on the critically of the clock and the application. Additionally, there might be a power consumption target that must be met and the jitter increase might be acceptable.

For illustration, we can take three clocks of a computing system with similar specs as follows: TIE (or jitter) < 40ps, a duty cycle of 46% to 54%, and nominal power consumption (e.g., 1mW, max consumption 2mW when allowed). The clock frequency can be one of 38.4 MHz, 100 MHz, and 300 MHz. The low-pass filter bandwidth tunability can be from 50 MHz to 400 MHz.

In some aspects, the RFI filter bandwidth depends on the main clock frequency, it must be higher than the frequency of oscillation but not higher than the expected RF interference. Additionally, if the RF interferer is too close (between 10 to 50 MHz) to the clock frequency, the low-pass filter has a minimum effect and can be disabled.

To demonstrate the different use cases, we can take the case when RFI only affects the jitter. Then, table 900 shows the different scenarios for when each element of the disclosed RFI mitigation architecture is enabled or disabled.

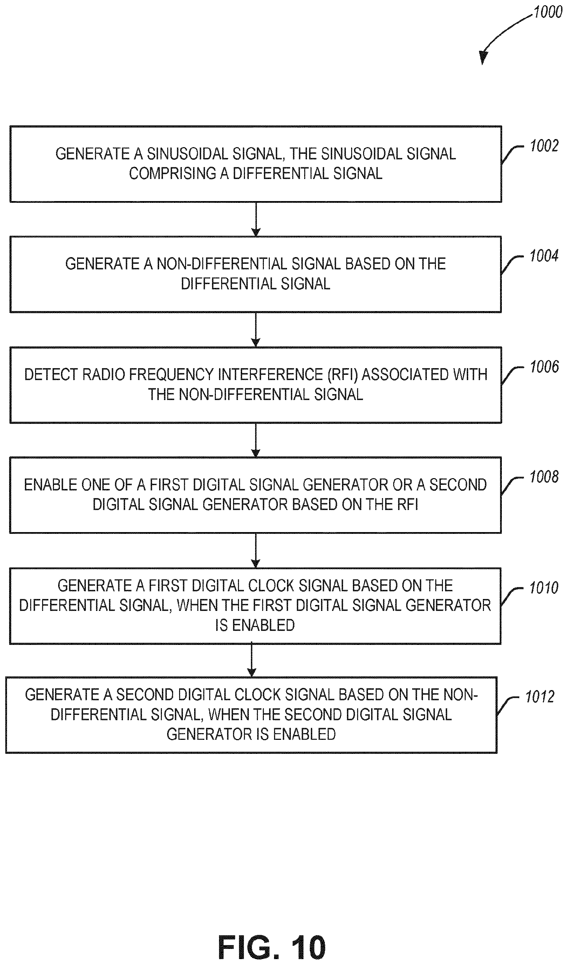

FIG. 10 is a flow diagram of an example method 1000 for RFI mitigation during clock generation, in accordance with some embodiments. Referring to FIG. 10, method 1000 includes operations 1002, 1004, 1006, 1008, 1010, and 1012, which may be executed by a memory configuration circuit or another processor of a computing device (e.g., hardware processor 1102 of device 1100 illustrated in FIG. 11).

At operation 1002, a sinusoidal signal is generated, where the sinusoidal signal includes a differential signal.

At operation 1004, a non-differential signal is generated based on the differential signal.

At operation 1006, radio frequency interference (RFI) associated with the non-differential signal is detected.

At operation 1008, one of a first digital signal generator or a second digital signal generator is enabled based on the RFI.

At operation 1010, a first digital clock signal is generated based on the differential signal, when the first digital signal generator is enabled.

At operation 1012, a second digital clock signal is generated based on the non-differential signal, when the second digital signal generator is enabled.

FIG. 11 illustrates a block diagram of an example machine 1100 upon which any one or more of the techniques (e.g., methodologies) discussed herein may perform. In alternative embodiments, the machine 1100 may operate as a standalone device or may be connected (e.g., networked) to other machines. In a networked deployment, machine 1100 may operate in the capacity of a server machine, a client machine, or both in server-client network environments. In an example, machine 1100 may act as a peer machine in a peer-to-peer (P2P) (or other distributed) network environment. The machine 1100 may be a personal computer (PC), a tablet PC, a set-top box (STB), a personal digital assistant (PDA), a portable communications device, a mobile telephone, a smartphone, a web appliance, a network router, switch or bridge, or any machine capable of executing instructions (sequential or otherwise) that specify actions to be taken by that machine. Further, while only a single machine is illustrated, the term "machine" shall also be taken to include any collection of machines that individually or jointly execute a set (or multiple sets) of instructions to perform any one or more of the methodologies discussed herein, such as cloud computing, software as a service (SaaS), other computer cluster configurations.

Machine (e.g., computer system) 1100 may include a hardware processor 1102 (e.g., a central processing unit (CPU), a graphics processing unit (GPU), a hardware processor core, or any combination thereof), a main memory 1104, and a static memory 1106, some or all of which may communicate with each other via an interlink (e.g., bus) 1108. In some aspects, the main memory 1104, the static memory 1106, or any other type of memory (including cache memory) used by the machine 1100 can be configured based on the disclosed techniques or can implement the disclosed memory devices.

Specific examples of main memory 1104 include Random Access Memory (RAM), and semiconductor memory devices, which may include, in some embodiments, storage locations in semiconductors such as registers. Specific examples of static memory 1106 include non-volatile memory, such as semiconductor memory devices (e.g., Electrically Programmable Read-Only Memory (EPROM), Electrically Erasable Programmable Read-Only Memory (EEPROM)) and flash memory devices; magnetic disks, such as internal hard disks and removable disks; magneto-optical disks; RAM; and CD-ROM and DVD-ROM disks.

Machine 1100 may further include a display device 1110, an input device 1112 (e.g., a keyboard), and a user interface (UI) navigation device 1114 (e.g., a mouse). In an example, the display device 1110, input device 1112, and UI navigation device 1114 may be a touch screen display. The machine 1100 may additionally include a storage device (e.g., drive unit or another mass storage device) 1116, a signal generation device 1118 (e.g., a speaker), a network interface device 1120, and one or more sensors 1121, such as a global positioning system (GPS) sensor, compass, accelerometer, or other sensors. The machine 1100 may include an output controller 1128, such as a serial (e.g., universal serial bus (USB), parallel, or other wired or wireless (e.g., infrared (IR), near field communication (NFC), etc.) connection to communicate or control one or more peripheral devices (e.g., a printer, card reader, etc.). In some embodiments, the processor 1102 and/or instructions 1124 may comprise processing circuitry and/or transceiver circuitry.

The storage device 1116 may include a machine-readable medium 1122 on which is stored one or more sets of data structures or instructions 1124 (e.g., software) embodying or utilized by any one or more of the techniques or functions described herein. The instructions 1124 may also reside, completely or at least partially, within the main memory 1104, within static memory 1106, or the hardware processor 1102 during execution thereof by the machine 1100. In an example, one or any combination of the hardware processor 1102, the main memory 1104, the static memory 1106, or the storage device 1116 may constitute machine-readable media.

Specific examples of machine-readable media may include non-volatile memory, such as semiconductor memory devices (e.g., EPROM or EEPROM) and flash memory devices; magnetic disks, such as internal hard disks and removable disks; magneto-optical disks; RAM; and CD-ROM and DVD-ROM disks.

While the machine-readable medium 1122 is illustrated as a single medium, the term "machine-readable medium" may include a single medium or multiple media (e.g., a centralized or distributed database, and/or associated caches and servers) configured to store instructions 1124.

An apparatus of the machine 1100 may be one or more of a hardware processor 1102 (e.g., a central processing unit (CPU), a graphics processing unit (GPU), a hardware processor core, or any combination thereof), a main memory 1104 and a static memory 1106, one or more sensors 1121, a network interface device 1120, one or more antennas 1160, a display device 1110, an input device 1112, a UI navigation device 1114, a storage device 1116, instructions 1124, a signal generation device 1118, and an output controller 1128. The apparatus may be configured to perform one or more of the methods and/or operations disclosed herein. The apparatus may be intended as a component of machine 1100 to perform one or more of the methods and/or operations disclosed herein, and/or to perform a portion of one or more of the methods and/or operations disclosed herein. In some embodiments, the apparatus may include a pin or other means to receive power. In some embodiments, the apparatus may include power conditioning hardware.

The term "machine-readable medium" may include any medium that is capable of storing, encoding, or carrying instructions for execution by machine 1100 and that causes the machine 1100 to perform any one or more of the techniques of the present disclosure, or that is capable of storing, encoding or carrying data structures used by or associated with such instructions. Non-limiting machine-readable medium examples may include solid-state memories and optical and magnetic media. Specific examples of machine-readable media may include non-volatile memory, such as semiconductor memory devices (e.g., Electrically Programmable Read-Only Memory (EPROM), Electrically Erasable Programmable Read-Only Memory (EEPROM)) and flash memory devices; magnetic disks, such as internal hard disks and removable disks; magneto-optical disks; Random Access Memory (RAM); and CD-ROM and DVD-ROM disks. In some examples, machine-readable media may include non-transitory machine-readable media. In some examples, machine-readable media may include machine-readable media that is not a transitory propagating signal.

The instructions 1124 may further be transmitted or received over a communications network 1126 using a transmission medium via the network interface device 1120 utilizing any one of several transfer protocols (e.g., frame relay, internet protocol (IP), transmission control protocol (TCP), user datagram protocol (UDP), hypertext transfer protocol (HTTP), etc.). Example communication networks may include a local area network (LAN), a wide area network (WAN), a packet data network (e.g., the Internet), mobile telephone networks (e.g., cellular networks), Plain Old Telephone (POTS) networks, and wireless data networks (e.g., Institute of Electrical and Electronics Engineers (IEEE) 802.11 family of standards known as Wi-Fi^{®}, IEEE 802.16 family of standards known as WiMax^{®}), IEEE 802.15.4 family of standards, a Long Term Evolution (LTE) family of standards, a Universal Mobile Telecommunications System (UMTS) family of standards, peer-to-peer (P2P) networks, among others.

In an example, the network interface device 1120 may include one or more physical jacks (e.g., Ethernet, coaxial, or phone jacks) or one or more antennas to connect to the communications network 1126. In an example, the network interface device 1120 may include one or more antennas 1160 to wirelessly communicate using at least one single-input multiple-output (SIMO), multiple-input multiple-output (MIMO), or multiple-input single-output (MISO) techniques. In some examples, the network interface device 1120 may wirelessly communicate using Multiple User MIMO techniques. The term "transmission medium" shall be taken to include any intangible medium that is capable of storing, encoding, or carrying instructions for execution by the machine 1100, and includes digital or analog communications signals or other intangible media to facilitate communication of such software.

Examples, as described herein, may include, or may operate on, logic or several components, modules, or mechanisms. Modules are tangible entities (e.g., hardware) capable of performing specified operations and may be configured or arranged in a certain manner. In an example, circuits may be arranged (e.g., internally or concerning external entities such as other circuits) in a specified manner as a module. In an example, the whole or part of one or more computer systems (e.g., a standalone, client, or server computer system) or one or more hardware processors may be configured by firmware or software (e.g., instructions, an application portion, or an application) as a module that operates to perform specified operations. In an example, the software may reside on a machine-readable medium. In an example, the software, when executed by the underlying hardware of the module, causes the hardware to perform the specified operations.

Accordingly, the term "module" is understood to encompass a tangible entity, be that an entity that is physically constructed, specifically configured (e.g., hardwired), or temporarily (e.g., transitorily) configured (e.g., programmed) to operate in a specified manner or to perform part or all of any operation described herein. Considering examples in which modules are temporarily configured, each of the modules need not be instantiated at any one moment in time. For example, where the modules comprise a general-purpose hardware processor configured using the software, the general-purpose hardware processor may be configured as respective different modules at different times. The software may accordingly configure a hardware processor, for example, to constitute a particular module at one instance of time and to constitute a different module at a different instance of time.

Some embodiments may be implemented fully or partially in software and/or firmware. This software and/or firmware may take the form of instructions contained in or on a non-transitory computer-readable storage medium. Those instructions may then be read and executed by one or more processors to enable the performance of the operations described herein. The instructions may be in any suitable form, such as but not limited to source code, compiled code, interpreted code, executable code, static code, dynamic code, and the like. Such a computer-readable medium may include any tangible non-transitory medium for storing information in a form readable by one or more computers, such as but not limited to read-only memory (ROM); random access memory (RAM); magnetic disk storage media; optical storage media; flash memory, etc.

The above-detailed description includes references to the accompanying drawings, which form a part of the detailed description. The drawings show, by way of illustration, specific embodiments that may be practiced. These embodiments are also referred to herein as "examples." Such examples may include elements in addition to those shown or described. However, also contemplated are examples that include the elements shown or described. Moreover, also contemplated are examples using any combination or permutation of those elements shown or described (or one or more aspects thereof), either with respect to a particular example (or one or more aspects thereof) or with respect to other examples (or one or more aspects thereof) shown or described herein.

Publications, patents, and patent documents referred to in this document are incorporated by reference herein in their entirety, as though individually incorporated by reference. In the event of inconsistent usage between this document and those documents so incorporated by reference, the usage in the incorporated reference(s) is supplementary to that of this document; for irreconcilable inconsistencies, the usage in this document controls.

In this document, the terms "a" or "an" are used, as is common in patent documents, to include one or more than one, independent of any other instances or usages of "at least one" or "one or more." In this document, the term "or" is used to refer to a nonexclusive or, such that "A or B" includes "A but not B," "B but not A," and "A and B," unless otherwise indicated. In the appended claims, the terms "including" and "in which" are used as the plain-English equivalents of the respective terms "comprising" and "wherein." Also, in the following claims, the terms "including" and "comprising" are open-ended, that is, a system, device, article, or process that includes elements in addition to those listed after such a term in a claim are still deemed to fall within the scope of that claim. Moreover, in the following claims, the terms "first," "second," and "third," etc. are used merely as labels and are not intended to suggest a numerical order for their objects.

The embodiments as described above may be implemented in various hardware configurations that may include a processor for executing instructions that perform the techniques described. Such instructions may be contained in a machine-readable medium such as a suitable storage medium or a memory or other processor-executable medium.

The embodiments as described herein may be implemented in several environments such as part of a wireless local area network (WLAN), 3rd Generation Partnership Project (3GPP) Universal Terrestrial Radio Access Network (UTRAN), or Long-Term-Evolution (LTE) or a Long-Term-Evolution (LTE) communication system, although the scope of the disclosure is not limited in this respect.

Antennas referred to herein may comprise one or more directional or omnidirectional antennas, including, for example, dipole antennas, monopole antennas, patch antennas, loop antennas, microstrip antennas, or other types of antennas suitable for transmission of RF signals. In some embodiments, instead of two or more antennas, a single antenna with multiple apertures may be used. In these embodiments, each aperture may be considered a separate antenna. In some multiple-input multiple-output (MIMO) embodiments, antennas may be effectively separated to take advantage of spatial diversity and the different channel characteristics that may result between each antenna and the antennas of a transmitting station. In some MIMO embodiments, antennas may be separated by up to 1/10 of a wavelength or more.

Described implementations of the subject matter can include one or more features, alone or in combination as illustrated below by way of examples.

Example 1 is an apparatus comprising: an oscillator circuit; a low-pass filter circuit coupled to an output terminal of the oscillator circuit; a first digital signal generator coupled to at least one of an output terminal of the low-pass filter circuit and the output terminal of the oscillator circuit, the first digital signal generator to generate a first digital clock signal based on a differential signal output of the oscillator circuit; a second digital signal generator coupled to at least one of the output terminal of the low-pass filter circuit and the output terminal of the oscillator circuit, the second digital signal generator to generate a second digital clock signal based on a non-differential signal output of the oscillator circuit; and a radio frequency interference (RFI) detection circuit coupled to the first digital signal generator and the second digital signal generator, the RFI detection circuit to detect RFI associated with the non-differential signal output of the oscillator circuit.

In Example 2, the subject matter of Example 1 includes subject matter where the oscillator circuit comprises a crystal coupled to at least two capacitors and a biasing resistor, and wherein the differential signal output is configured at a terminal of the crystal and a terminal of the biasing resistor.

In Example 3, the subject matter of Example 2 includes subject matter where the non-differential signal output is configured at the terminal of the crystal.

In Example 4, the subject matter of Examples 1-3 includes subject matter where the oscillator circuit is a Pierce oscillator circuit.

In Example 5, the subject matter of Examples 1-4 includes, an actuator circuit coupled to the RFI detection circuit, the actuator circuit to generate one or more control signals based on the RFI detected by the RFI detection circuit.

In Example 6, the subject matter of Example 5 includes subject matter where the actuator circuit is to enable at least one of the low-pass filter circuit, the first digital signal generator, and the second digital signal generator based on the one or more control signals.

In Example 7, the subject matter of Examples 5-6 includes subject matter where when the RFI is equal to or is above a first threshold, the one or more control signals: enable the low-pass filter circuit and the first digital signal generator; and disable the second digital signal generator.

In Example 8, the subject matter of Examples 5-7 includes subject matter where when the RFI is equal to or is above a first threshold and a power consumption level of the apparatus is above a second threshold, the one or more control signals: enable the low-pass filter circuit and the second digital signal generator; and disable the first digital signal generator.

In Example 9, the subject matter of Examples 7-8 includes subject matter where when the RFI is below the first threshold, the one or more control signals: disable the low-pass filter circuit and the first digital signal generator; and enable the second digital signal generator.

In Example 10, the subject matter of Examples 6-9 includes subject matter where the RFI detection circuit further detects a frequency of the RFI.

In Example 11, the subject matter of Example 10 includes subject matter where the one or more control signals include a filter tuning signal to cause filter bandwidth tuning of the low-pass filter circuit based on the frequency of the RFI.

In Example 12, the subject matter of Examples 5-11 includes, a first switch coupled to the output terminal of the low-pas filter; a second switch coupled to an input terminal of the first digital signal generator; a third switch coupled to the output terminal of the oscillator circuit; and a fourth switch coupled to the input terminal of the second digital signal generator.

In Example 13, the subject matter of Example 12 includes subject matter where activation of the first switch causes deactivation of the third switch, and deactivation of the first switch causes activation of the third switch.

In Example 14, the subject matter of Examples 12-13 includes subject matter where activation of the second switch causes deactivation of the fourth switch, and deactivation of the second switch causes activation of the fourth switch.

In Example 15, the subject matter of Examples 12-14 includes subject matter where asserting the one or more control signals causes activation or deactivation of at least one of the first switch, the second switch, the third switch, and the fourth switch.

In Example 16, the subject matter of Examples 1-15 includes subject matter where the RFI detection circuit comprises: a jitter monitoring circuit configured to detect a jitter level associated with the non-differential signal output of the oscillator circuit; and a duty cycle monitoring circuit configured to detect a deviation in a duty cycle associated with the non-differential signal output of the oscillator circuit.

In Example 17, the subject matter of Example 16 includes subject matter where the RFI detection circuit is to determine the RFI based on the jitter level being higher than a pre-configured jitter threshold.

In Example 18, the subject matter of Examples 16-17 includes subject matter where the RFI detection circuit is to determine the RFI based on the deviation in the duty cycle associated with the non-differential signal output of the oscillator circuit being higher than a pre-configured duty cycle threshold.

In Example 19, the subject matter of Examples 1-18 includes subject matter where the apparatus comprises one or more interfaces coupled to at least one of the oscillator circuit, the low-pass filter circuit, the first digital signal generator, the second digital signal generator, and the RFI detection circuit.

In Example 20, the subject matter of Examples 1-19 includes subject matter where the apparatus comprises one or more interconnects coupling two or more of the oscillator circuit, the low-pass filter circuit, the first digital signal generator, the second digital signal generator, and the RFI detection circuit.

In Example 21, the subject matter of Examples 1-20 includes subject matter where the apparatus comprises a processor, and wherein the processor includes the oscillator circuit, the low-pass filter circuit, the first digital signal generator, the second digital signal generator, and the RFI detection circuit.

Example 22 is an apparatus comprising: a low-pass filter circuit, the low-pass filtering circuit to receive a sinusoidal signal; a first digital signal generator coupled to an output terminal of the low-pass filter circuit, the first digital signal generator to generate a first digital clock signal based a differential signal corresponding to the sinusoidal signal; a second digital signal generator coupled to an input terminal of the first digital signal generator, the second digital signal generator to generate a second digital clock signal based on a non-differential signal corresponding to the differential signal; and a radio frequency interference (RFI) detection circuit coupled to the first digital signal generator and the second digital signal generator, the RFI detection circuit to detect RFI associated with the non-differential signal.

In Example 23, the subject matter of Example 22 includes, an oscillator circuit to generate the sinusoidal signal, the oscillator circuit comprising a crystal coupled to at least two capacitors and a biasing resistor, and wherein the differential signal is generated at a terminal of the crystal and a terminal of the biasing resistor.

In Example 24, the subject matter of Example 23 includes subject matter where the non-differential signal is generated at the terminal of the crystal.

In Example 25, the subject matter of Examples 23-24 includes subject matter where the oscillator circuit is a Pierce oscillator circuit.

In Example 26, the subject matter of Examples 25-25 includes, an actuator circuit coupled to the RFI detection circuit, the actuator circuit to generate one or more control signals based on the RFI detected by the RFI detection circuit.

In Example 27, the subject matter of Example 26 includes subject matter where the actuator circuit is to enable at least one of the low-pass filter circuit, the first digital signal generator, and the second digital signal generator based on the one or more control signals.

In Example 28, the subject matter of Examples 26-27 includes subject matter where when the RFI is equal to or is above a first threshold, the one or more control signals: enable the low-pass filter circuit and the first digital signal generator; and disable the second digital signal generator.

In Example 29, the subject matter of Examples 26-28 includes subject matter where when the RFI is equal to or is above a first threshold and a power consumption level of the apparatus is above a second threshold, the one or more control signals: enable the low-pass filter circuit and the second digital signal generator; and disable the first digital signal generator.

In Example 30, the subject matter of Examples 28-29 includes subject matter where when the RFI is below the first threshold, the one or more control signals: disable the low-pass filter circuit and the first digital signal generator; and enable the second digital signal generator.

In Example 31, the subject matter of Examples 30-30 includes subject matter where the RFI detection circuit further detects a frequency of the RFI.

In Example 32, the subject matter of Example 31 includes subject matter where the one or more control signals include a filter tuning signal to cause filter bandwidth tuning of the low-pass filter circuit based on the frequency of the RFI.

In Example 33, the subject matter of Examples 26-32 includes, a first switch coupled to the output terminal of the low-pas filter; a second switch coupled to an input terminal of the first digital signal generator; a third switch coupled to an input of the low-pass filter circuit; and a fourth switch coupled to the input terminal of the second digital signal generator.

In Example 34, the subject matter of Example 33 includes subject matter where activation of the first switch causes deactivation of the third switch, and deactivation of the first switch causes activation of the third switch.

In Example 35, the subject matter of Examples 33-34 includes subject matter where activation of the second switch causes deactivation of the fourth switch, and deactivation of the second switch causes activation of the fourth switch.

In Example 36, the subject matter of Examples 33-35 includes subject matter where asserting the one or more control signals causes activation or deactivation of at least one of the first switch, the second switch, the third switch, and the fourth switch.

In Example 37, the subject matter of Examples 22-36 includes subject matter where the RFI detection circuit comprises: a jitter monitoring circuit configured to detect a jitter level associated with the non-differential signal output of the oscillator circuit; and a duty cycle monitoring circuit configured to detect a deviation in a duty cycle associated with the non-differential signal output of the oscillator circuit.

In Example 38, the subject matter of Example 37 includes subject matter where the RFI detection circuit is to determine the RFI based on the jitter level being higher than a pre-configured jitter threshold.

In Example 39, the subject matter of Examples 37-38 includes subject matter where the RFI detection circuit is to determine the RFI based on the deviation in the duty cycle associated with the non-differential signal output being higher than a pre-configured duty cycle threshold.

In Example 40, the subject matter of Examples 22-39 includes subject matter where the apparatus comprises one or more interfaces coupled to at least one of the low-pass filter circuit, the first digital signal generator, the second digital signal generator, and the RFI detection circuit.

In Example 41, the subject matter of Examples 22-40 includes subject matter where the apparatus comprises one or more interconnects coupling two or more of the low-pass filter circuit, the first digital signal generator, the second digital signal generator, and the RFI detection circuit.

In Example 42, the subject matter of Examples 22-41 includes subject matter where the apparatus comprises a processor, and wherein the processor includes the low-pass filter circuit, the first digital signal generator, the second digital signal generator, and the RFI detection circuit.

Example 43 is a method comprising: generating a sinusoidal signal, the sinusoidal signal comprising a differential signal; generating a non-differential signal based on the differential signal; detecting radio frequency interference (RFI) associated with the non-differential signal; enabling one of a first digital signal generator or a second digital signal generator based on the RFI; generating a first digital clock signal based on the differential signal, when the first digital signal generator is enabled; and generating a second digital clock signal based on the non-differential signal, when the second digital signal generator is enabled.

In Example 44, the subject matter of Example 43 includes, generating one or more control signals based on the RFI.

In Example 45, the subject matter of Example 44 includes, enabling at least one of a low-pass filter circuit, the first digital signal generator, and the second digital signal generator based on the one or more control signals.

In Example 46, the subject matter of Examples 44-45 includes subject matter where when the RFI is equal to or is above a first threshold, the method comprises: performing based on the one or more control signals: enabling the low-pass filter circuit to filter the differential signal; and enabling the first digital signal generator to generate the first digital clock signal.

In Example 47, the subject matter of Examples 44-46 includes subject matter where when the RFI is equal to or is above a first threshold and a power consumption level of an apparatus receiving the first digital clock signal or the second digital clock signal is above a second threshold, the method comprises: performing based on the one or more control signals: enabling the low-pass filter circuit to filter the differential signal; enabling the second digital signal generator to generate the second digital clock signal; and disabling the first digital signal generator.

In Example 48, the subject matter of Examples 46-47 includes subject matter where when the RFI is below the first threshold, the method comprises: performing based on the one or more control signals: disabling the low-pass filter circuit and the first digital signal generator; and enabling the second digital signal generator to generate the second digital clock signal.

Example 49 is a system comprising: memory; and at least one hardware processor coupled to the memory, the at least one hardware processor to: generate a sinusoidal signal, the sinusoidal signal comprising a differential signal; generate a non-differential signal based on the differential signal; detect radio frequency interference (RFI) associated with the non-differential signal; enable one of a first digital signal generator or a second digital signal generator based on the RFI; generate a first digital clock signal based on the differential signal, when the first digital signal generator is enabled; and generate a second digital clock signal based on the non-differential signal, when the second digital signal generator is enabled.

In Example 50, the subject matter of Example 49 includes subject matter where the at least one hardware processor is to: generate one or more control signals based on the RFI.

In Example 51, the subject matter of Example 50 includes subject matter where the at least one hardware processor is to: enable at least one of a low-pass filter circuit, the first digital signal generator, and the second digital signal generator based on the one or more control signals.

Example 52 is at least one machine-readable medium including instructions that, when executed by processing circuitry, cause the processing circuitry to perform operations to implement of any of Examples 1-51.

Example 53 is an apparatus comprising means to implement any of Examples 1-51.

Example 54 is a system to implement any of Examples 1-51.

Example 55 is a method to implement any of Examples 1-51.

The above description is intended to be illustrative, and not restrictive. For example, the above-described examples (or one or more aspects thereof) may be used in combination with others. Other embodiments may be used, such as by one of ordinary skill in the art upon reviewing the above description. The Abstract is to allow the reader to quickly ascertain the nature of the technical disclosure. It is submitted with the understanding that it will not be used to interpret or limit the scope or meaning of the claims. Also, in the above Detailed Description, various features may be grouped to streamline the disclosure. However, the claims may not set forth every feature disclosed herein as embodiments may feature a subset of said features. Further, embodiments may include fewer features than those disclosed in a particular example. Thus, the following claims are hereby incorporated into the Detailed Description, with a claim standing on its own as a separate embodiment. The scope of the embodiments disclosed herein is to be determined regarding the appended claims, along with the full scope of equivalents to which such claims are entitled.

## Claims

1. An apparatus comprising:
an oscillator circuit;
a low-pass filter circuit coupled to an output terminal of the oscillator circuit;
a first digital signal generator coupled to at least one of an output terminal of the low-pass filter circuit and the output terminal of the oscillator circuit, the first digital signal generator to generate a first digital clock signal based on a differential signal output of the oscillator circuit;
a second digital signal generator coupled to at least one of the output terminal of the low-pass filter circuit and the output terminal of the oscillator circuit, the second digital signal generator to generate a second digital clock signal based on a non-differential signal output of the oscillator circuit; and
a radio frequency interference (RFI) detection circuit coupled to the first digital signal generator and the second digital signal generator, the RFI detection circuit to detect RFI associated with the non-differential signal output of the oscillator circuit.

2. The apparatus of claim 1, wherein the oscillator circuit comprises a crystal coupled to at least two capacitors and a biasing resistor, and wherein the differential signal output is configured at a terminal of the crystal and a terminal of the biasing resistor.

3. The apparatus of claim 2, wherein the non-differential signal output is configured at the terminal of the crystal.

4. The apparatus of claim 1, wherein the oscillator circuit is a Pierce oscillator circuit.

5. The apparatus of claim 1, further comprising:
an actuator circuit coupled to the RFI detection circuit, the actuator circuit to generate one or more control signals based on the RFI detected by the RFI detection circuit,
wherein the actuator circuit is to enable at least one of the low-pass filter circuit, the first digital signal generator, and the second digital signal generator based on the one or more control signals.

6. The apparatus of claim 5, wherein when the RFI is equal to or is above a first threshold, the one or more control signals:
enable the low-pass filter circuit and the first digital signal generator; and
disable the second digital signal generator.

7. The apparatus of claim 5, wherein when the RFI is equal to or is above a first threshold and a power consumption level of the apparatus is above a second threshold, the one or more control signals:
enable the low-pass filter circuit and the second digital signal generator; and
disable the first digital signal generator.

8. The apparatus of claim 6, wherein when the RFI is below the first threshold, the one or more control signals:
disable the low-pass filter circuit and the first digital signal generator; and
enable the second digital signal generator.

9. The apparatus of claim 1, wherein the apparatus comprises:
one or more interfaces coupled to at least one of the oscillator circuit, the low-pass filter circuit, the first digital signal generator, the second digital signal generator, and the RFI detection circuit; and
one or more interconnects coupling two or more of the oscillator circuit, the low-pass filter circuit, the first digital signal generator, the second digital signal generator, and the RFI detection circuit.

10. The apparatus of claim 1, wherein the apparatus comprises a processor, and wherein the processor includes the oscillator circuit, the low-pass filter circuit, the first digital signal generator, the second digital signal generator, and the RFI detection circuit.

11. A method comprising:
generating a sinusoidal signal, the sinusoidal signal comprising a differential signal;
generating a non-differential signal based on the differential signal;
detecting radio frequency interference (RFI) associated with the non-differential signal;
enabling one of a first digital signal generator or a second digital signal generator based on the RFI;
generating a first digital clock signal based on the differential signal, when the first digital signal generator is enabled; and
generating a second digital clock signal based on the non-differential signal, when the second digital signal generator is enabled.

12. The method of claim 11, further comprising:
generating one or more control signals based on the RFI;
enabling at least one of a low-pass filter circuit, the first digital signal generator, and the second digital signal generator based on the one or more control signals; and
wherein when the RFI is equal to or is above a first threshold, the method further comprises:
performing based on the one or more control signals:
enabling the low-pass filter circuit to filter the differential signal; and
enabling the first digital signal generator to generate the first digital clock signal.
